# EUROPÄISCHE PATENTANMELDUNG

(11) **EP 0 631 392 A1**
(43) Veröffentlichungstag der Anmeldung: **28.12.1994**
(21) Anmeldenummer: 94109353.6
(22) Anmeldetag: 17.06.1994
(51) Int. Cl.: H03M 1/12

(54) **Anordnung zur Abtastung eines analogen Signals mit wählbarer Abtastfrequenz**

(30) Priorität: 25.06.1993 DE 4321120
(71) Anmelder: GRUNDIG E.M.V. Elektro-Mechanische Versuchsanstalt Max Grundig GmbH & Co. KG, D-90762 Fürth (DE)
(72) Erfinder: Ziegler, Cornelius, Dipl.-Ing., GRUNDIG E.M.V., D-90748 Fürth (DE)

(57) **Zusammenfassung**

Werden bei der Abtastung von analogen Signalen unterschiedliche Abtastfrequenzen zugelassen, tritt das Problem auf, daß die Tiefpaßfilterung vor der Abtastung der jeweiligen Abtastfrequenz angepaßt sein muß, um Interferenzstörungen (Aliasing) zu vermeiden, bzw. um die gewünschte Signalbandbreite vollständig abtasten zu können.

Bei der vorliegenden Erfindung wird diese Anpassung auf einfache Weise und mit geringem Aufwand dadurch erreicht, daß ein Filter mit geschalteten Kapazitäten verwendet wird, dessen Grenzfrequenz durch eine entsprechend gewählte Taktfrequenz an die jeweilige Abtastfrequenz angepaßt werden kann.

## Beschreibung

Die Erfindung betrifft eine Anordnung zur Abtastung eines analogen Signals mit wählbarer Abtastfrequenz, gemäß dem Oberbegriff des Patentanspruchs 1.

Für die Darstellung von rasterförmig aufgebauten Bildsignalen kann es nötig werden, die Bildsignale mit unterschiedlichen Abtastfrequenzen für die weitere Verarbeitung zu digitalisieren. Dies ist z.B. dann nötig, wenn das Raster des darzustellenden Bildsignals mehr Bildpunkte aufweist, als auf der Einrichtung zur Darstellung, beispielsweise einem Fernsehgerät, dargestellt werden können. Soll der gesamte Bildinhalt des Bildsignals dargestellt werden, muß die Abtastfrequenz niedrig sein, bei Darstellung nur eines Ausschnittes muß die Abtastfrequenz entsprechend größer sein. Derartige Bildsignale sind u.a. von Wettersatelliten bekannt.

Die Wettersatelliten bilden eine wichtige Informationsquelle für Meteorologen. Mit Hilfe der Wettersatelliten werden Daten übertragen, aus denen die Geschwindigkeit von Luftströmungen, Temperaturen von verschiedenen Meeresströmungen, Wolkenbewegungen und vieles mehr bestimmt werden können. Diese Daten werden sowohl von Forschern ausgewertet, um grundsätzliche Klimaveränderungen zu erkennen als auch von Meteorologen, die kurzfristige Wettervorhersagen aus den erhaltenen Informationen ableiten können.

Zur Aufnahme von Bildern wird beispielsweise beim Meteosat, einem geostationären europäischen Wettersatelliten ein Radiometer mit drei verschiedenen Spektralbereichen verwendet, das die Erde zeilenweise abtastet.

Der erste von Meteosat aufgenommene Frequenzbereich umfaßt die Lichtwellenlängen von 0,4µm bis 1,1µm. In diesem Bereich stehen zwei Kanäle zur Verfügung. Pro Bild werden 5000 Zeilen und 5000 Bildpunkte übertragen, was zu einer Auflösung von etwa 2,5km pro Bildpunkt führt.

Im IR-Bereich mit den Lichtwellenlängen von 5,7µm bis 7,1µm hat man einen Kanal zur Verfügung, der 2500 x 2500 Bildpunkte auflöst. In diesem Frequenzbereich wird der Wasserdampfgehalt der oberen Troposphäre aufgenommen. In der Bilddarstellung erscheinen Bereiche mit hohem Wasserdampfgehalt hell und Bereiche mit niedrigem Wasserdampfgehalt dunkel.

Ein zweiter IR-Bereich mit den Lichtwellenlängen von 10,5µm bis 12,5µm wird auf zwei Kanälen übertragen, von denen einer redundant ist. Die empfangene Strahldichte in diesem Frequenzbereich hängt von der Temperatur der aufgenommenen Oberfläche ab. Kalte Oberflächenbereiche erzeugen eine geringe Strahldichte und somit ein helles Bild. Warme Oberflächen erzeugen dunkle Bildbereiche.

Die im Satelliten aufgenommenen Bilder werden zur Erde gesendet und in einem Großrechner aufbereitet. Die im Großrechner bearbeiteten Bilder werden wieder an den Satelliten gesendet und von dort abgestrahlt.

Diese Bildsendungen können auf der Erde auf den Frequenzen 1694,5MHz und 1691,0MHz empfangen werden. Es wird mit horizontaler Polarisation bei einem Frequenzhub von ±9kHz gesendet. Pro Zeile werden 840 Bildpunkte übertragen, wobei die Übertragung einer Zeile 250ms dauert. Bei den geostationären Satelliten erfolgt die Bildaussendung nach einem vorgegenen Zeitplan, nach dem zu bestimmten Zeiten Bilder verschiedener Gebiete gesendet werden. Jede Übertragung eines Bildes beginnt mit einem Startsignal (300Hz-Ton, Dauer: 3s), einem Phasensignal (Dauer: 5s) und einem digitalen Kennsignal (zwei Bildzeilen), dem der Bildinhalt (800 x 800 Bildpunkte, Dauer: 200s) und ein Stoppsignal (450Hz-Ton, Dauer: 5s) folgen.

Sollen unterschiedliche Bildausschnitte betrachtet werden, tritt bei der dann notwendigen Verwendung unterschiedlicher Abtastfrequenzen das Problem auf, daß vor der Abtastung eine der jeweiligen Abtastfrequenz angepaßte Tiefpaßfilterung erfolgen muß, um Interferenzstörungen (Aliasing) zu vermeiden, bzw. um die gewünschte Signalbandbreite vollständig abtasten zu können.

Diese bei der Abtastung von analogen Signalen entstehenden Störungen werden beispielsweise in der Offenlegungsschrift DE 39 30 085 A1 erwähnt. Sie resultieren aus der Nichtbeachtung des Shannon-Abtastgesetzes.

Aufgabe der vorliegenden Erfindung ist es deshalb, eine Anordnung anzugeben, bei der die oben beschriebenen Probleme vermieden werden.

Erfindungemäß wird diese Aufgabe durch die Merkmale des Patentanspruchs 1 gelöst.

Der Vorteil der Erfindung liegt insbesondere darin, daß die Grenzfrequenz des Tiefpaßfilters auf einfache Weise und mit geringem Aufwand an die jeweilige Abtastfrequenz angepaßt werden kann.

Weitere Vorteile der Erfindung ergeben sich aus den Unteransprüchen und der nachfolgenden Beschreibung mittels zweier Figuren.

Es zeigt:
Figur 1 ein Blockschaltbild einer ersten Ausführungsform einer erfindungsgemäßen Anordnung, und
Figur 2 ein Blockschaltbild einer zweiten Ausführungsform einer erfindungsgemäßen Anordnung.

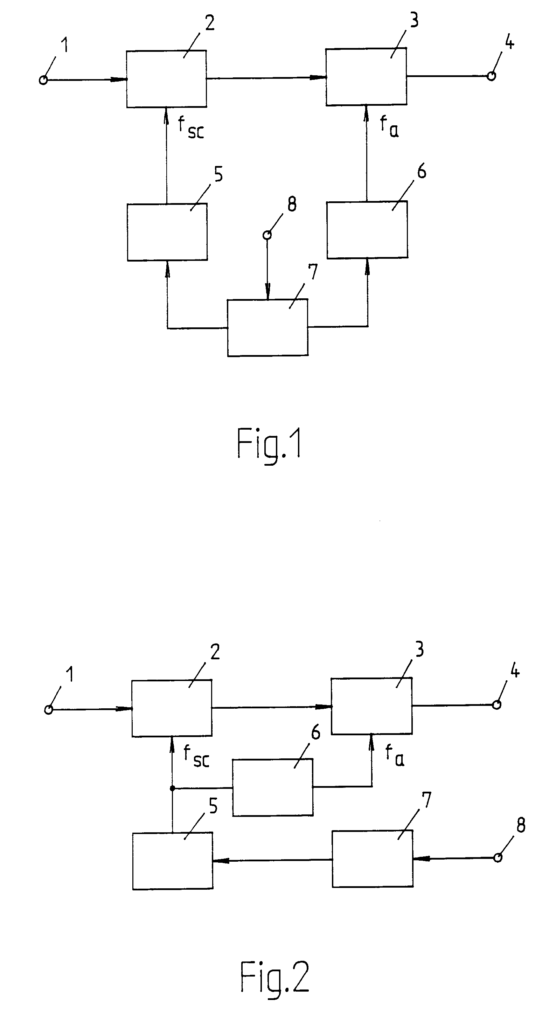

Die erfindungsgemäße Anordnung nach Figur 1 weist ein Tiefpaßfilter 2, einen Analog/Digital-Wandler 3, Oszillatoren 5, 6 und eine Einrichtung 7 auf. Das Tiefpaßfilter 2 weist geschaltete Kondensatoren auf (sog. switched capacitor filter), seine Grenzfrequenz ist durch die Taktfrequenz f_{sc} einstellbar, welche die Kondensatoren des Tiefpaßfilters 2 schaltet. Die Einrichtung 7 kann beispielsweise durch einen Mikrocomputer gebildet werden und über ein Steuersignal 8 kann der für die Darstellung gewünschte Bildausschnitt aus dem Gesamtbild ausgewählt werden. Dazu wird das am Eingang 1 anliegende Bildsignal tiefpaßgefiltert 2 und digitalisiert 3, worauf es zur weiteren Bearbeitung am Ausgang 4 zur Verfügung steht. Das Auswählen eines bestimmten Bildausschnitts ist an sich bekannt und wird deshalb nicht näher beschrieben.

Nach Maßgabe der über das Steuersignal 8 festgelegten Größe des darzustellenden Bildausschnitts steuert die Einrichtung 7 die Oszillatoren 5 und 6 an. Der Oszillator 6 erzeugt daraufhin eine Abtastfrequenz fₐ, entsprechend dem wiederzugebenden Bildausschnitt. Für große Bildausschnitte ist die Abtastfrequenz fₐ kleiner als für kleine Bildausschnitte, da in diesem Fall nicht alle zur Verfügung stehenden Bildpunkte abgetastet werden.

Die durch die Steuerung der Einrichtung 7 vom Oszillator 5 erzeugte Taktfrequenz f_{sc} stellt die Grenzfrequenz des Tiefpaßfilters 2 auf einen Wert ein, der kleiner oder gleich der halben Abtastfrequenz fₐ ist. Üblicherweise ist die dazu benötigte Taktfrequenz f_{sc} 50 bis 100mal so groß wie die Grenzfrequenz des Tiefpaßfilters 2.

Im Ausführungsbeispiel nach Figur 2 wird nur ein Oszillator 5 verwendet. Der Oszillator 5 erzeugt die für das Tiefpaßfilter 2 benötigte Taktfrequenz f_{sc}. Die für den Analog/Digital-Wandler 3 benötigte Abtastfrequenz fₐ wird mittels eines Frequenzteilers 6 aus dem Taktsignal f_{sc} gewonnen. Das einzustellende Teilungsverhältnis ergibt sich nach dem Abtasttheorem aus der Abtastfrequenz fₐ und ist der halbe Wert des oben erwähnten Faktors für die Taktfrequenz f_{sc}.

## Patentansprüche

1. Anordnung zur Abtastung eines analogen Signals mit wählbarer Abtastfrequenz, aufweisend
- ein Tiefpaßfilter (2), dessen Grenzfrequenz nach Maßgabe einer Taktfrequenz (f_{sc}) einstellbar ist,
- einem dem Tiefpaßfilter (2) nachgeschalteten Analog/Digital-Wandler (3),
- einer ersten Einrichtung (5) zur Erzeugung der Taktfrequenz für das Tiefpaßfilter,
- einer zweiten Einrichtung (6) zur Erzeugung einer Abtastfrequenz (fₐ) für den Analog/Digital-Wandler (3), und
- einer dritten Einrichtung (7) zur Einstellung des Wertes der gewählten Abtastfrequenz,
**dadurch gekennzeichnet,**
daß die dritte Einrichtung (7) nach Maßgabe des gewählten Werts der Abtastfrequenz (fₐ) die erste Einrichtung (5) derart ansteuert, daß die von der ersten Einrichtung (5) erzeugte Taktfrequenz (f_{sc}) die Grenzfrequenz des Tiefpaßfilters (2) auf einen Wert kleiner gleich der halben Abtastfrequenz (fₐ) festlegt.

2. Anordnung nach Anspruch 1,
**dadurch gekennzeichnet,**
daß das Tiefpaßfilter (2) geschaltete Kapazitäten aufweist.

3. Anordnung nach Anspruch 1 oder 2,
**dadurch gekennzeichnet,**
daß die dritte Einrichtung (7) von einem Mikrocomputer gebildet wird.

4. Anordnung nach einem der Ansprüche 1 bis 3,
**dadurch gekennzeichnet,**
daß die erste und zweite Einrichtung (5;6) zur Erzeugung der Abtastfrequenz (fₐ) und der Taktfrequenz (f_{sc}) von Oszillatoren gebildet werden.

5. Anordnung nach einem der Ansprüche 1 bis 3,
**dadurch gekennzeichnet,**
daß die erste Einrichtung (5) zur Erzeugung der Taktfrequenz (f_{sc}) von einem Oszillator gebildet wird, und daß die zweite Einrichtung (6) zur Erzeugung der Abtastfrequenz (fₐ) von einem Frequenzteiler gebildet wird, der die Abtastfrequenz aus der Taktfrequenz ableitet.

6. Anordnung nach einem der Ansprüche 1 bis 5,
**gekennzeichnet durch**
daß die dritte Einrichtung (7) die Taktfrequenz (f_{sc}) und die Abtastfrequenz (fₐ) nach Maßgabe der Größe des darzustellenden Bildbereichs einstellt.

7. Anordnung nach einem der Ansprüche 1 bis 6,
**gekennzeichnet durch**
die Verwendung zur Abtastung von Bildsignalen, welche von Wettersatelliten stammen.
